## Europäisches Patentamt

## European Patent Office

## Office européen des brevets

(19)

(11) Publication number: **0 124 277**
**B1**

# EUROPEAN PATENT SPECIFICATION

(12)

(45) Date of publication of patent specification: **28.12.88**

(51) Int. Cl.⁴: **H 01 L 29/64**

(21) Application number: **84302192.4**

(22) Date of filing: **30.03.84**

(54) **Field effect transistor for integrated circuits.**

(30) Priority: **01.04.83 JP 55225/83**

(43) Date of publication of application:
**07.11.84 Bulletin 84/45**

(45) Publication of the grant of the patent:
**28.12.88 Bulletin 88/52**

(84) Designated Contracting States:
**DE FR GB NL**

(56) References cited:
**US-A-3 996 656**

**JAPANESE JOURNAL OF APPLIED PHYSICS,
vol. 21, no. 11, November 1982, Tokyo, JP; K.
MURASE et al. "Amorphous silicon-
germanium-boron alloy applied to low-loss
and high-speed diodes", pages 1559-1565**

**Patent Abstracts of Japan vol. 4, no. 145, 14
October 1980 page 28E29 & JP-A-55-95370**

(73) Proprietor: **NIPPON TELEGRAPH AND
TELEPHONE CORPORATION
1-6 Uchisaiwaicho 1-chome Chiyoda-ku
Tokyo (JP)**

(72) Inventor: **Kurumada, Katsuhiko
3-7, Hamada-cho
Ebina-shi Kanagawa (JP)**
Inventor: **Murase, Katsumi
Denden 1-405, 861-1
Ishida Isehara-shi Kanagawa (JP)**
Inventor: **Asai, Kazuyoshi
Denden 2-404, 861-1
Ishida Isehara-shi Kanagawa (JP)**
Inventor: **Suzuki, Masamitsu
Denden 8-105, 861-1
Ishida Isehara-shi Kanagawa (JP)**
Inventor: **Amemiya, Yoshihito
11-1, Minami-Naruse 2-chome
Machida-shi Tokyo (JP)**
Inventor: **Ogino, Toshio
Denden 7-403, 861-1
Ishida Isehara-shi Kanagawa (JP)**
Inventor: **Mizushima, Yoshihiko
10-7, Koyanagi-cho 5-chome
Fuchu-shi Tokyo (JP)**

(74) Representative: **Wood, Anthony Charles
Urquhart-Dykes & Lord 91 Wimpole Street
London W1M 8AH (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

The present invention relates to a field effect transistor and, more particularly, to a field effect transistor for integrated circuits.

A typical conventional field effect transistor (to be referred to as an FET hereinafter) formed on a GaAs semi-insulating substrate has a metal electrode which, together with a GaAs-based Group III—V compound semiconductor, constitutes a Schottky barrier. There are only a small number of conventional FETs having an insulating gate film and a p-n junction gate. In the FETs having the insulating gate film this is because deviation in threshold value become large owing to charges trapped at the interface between the GaAs semiconductor and the insulating film. In addition, in the FET having the p-n junction gate, the gate length at the p-n junction cannot be less than 1 μm due to micropatterning limitations. Therefore, the conventional technique will be exemplified by the conventional GaAs FET having a Schottky barrier junction gate.

In the conventional GaAs Schottky barrier junction gate FET (to be referred to as a GaAs MESFET hereinafter), a metal gate electrode is selected from materials such as aluminum, gold, titanium, molybdenum, platinum and tantalum. The Schottky barrier electrical characteristics vary in accordance with different metal electrode materials and are reflected in a Schottky barrier height or energy difference ΦBN in the relation

$$Io \propto exp[q(V - \Phi BN)/kT]$$

representing a relationship between the Schottky barrier current Io and the forward biasing voltage V between the Schottky electrode and the n-type semiconductor layer, where q is the magnitude of electronic charge, k is the Boltzmann constant, and T is the absolute temperature. The Schottky barrier height ΦBN is a factor which determines a biasing voltage at which an abrupt increase in the Schottky barrier forward biasing current occurs.

Assuming that neither of an interface layer and interface electron states exists at the interface between a metal electrode and a semiconductor layer, the Schottky barrier height ΦBN is given by equation (1) below:

$$\Phi BN = \Phi M - \chi \qquad (1)$$

where ΦM is the work function of the electrode metal, and χ is the electron affinity. According to the ideal model, work functions of metals as electrodes which constitute Schottky junctions directly correspond to the Schottky barrier heights. However, the measured results of the Schottky barrier heights ΦBN greatly differ from those derived on the basis of the ideal model, as has been described in various references. The conventional measured results of the Schottky barrier potential difference ΦBN have the following tendency. The Fermi level EF at the Schottky barrier junction interface is almost fixed at an energy level (EG/3) above the valence band when the energy gap is given as EG. In other words, the Schottky barrier height ΦBN for an n-type semiconductor tends to be set at about 2EG/3, and, therefore, is restricted by the energy gap EG of the n-type semiconductor.

For example, in the case of n-type GaAs, it is generally known that the Schottky barrier height is given to be about 0.07ΦM+0.49 in accordance with measured values concerning several types of metal electrodes. This is reported by A. M. Lawley and S. M. Sze: "Surface States and Barrier Height of Metal-Semiconductor Systems", J. Appl. Phys. Vol. 36 (1965), P. 3212. Even if a variety of metals are applied to n-type GaAs, only 7/100 times metal work function difference is reflected to the Schottky barrier height difference. Therefore, the available range of the conventional Schottky barrier height ΦBN obtained falls within 0.7 V to 0.85 V.

In the general industrial process for fabricating MESFETs, when various types of Schottky barrier junction gate metals are used to vary the Schottky barrier height ΦBN, more than one gate metal deposition apparatus must be used. In addition to this disadvantage, the type of metal which may be used for wiring connected to the gate electrode is limited, resulting in inconvenience.

Therefore, the MESFETs have conventionally been designed under the assumption that the Schottky barrier height ΦBN is given to be a predetermined value.

The relation among the built-in voltage Vbi of the Schottky barrier which is determined corresponding to the Schottky barrier height ΦBN, the drain current Id, and the gate-source voltage VGS in the current saturation region of an FET is given as follows:

$$Id = 4KVp^2[(VGS - VT)/Vp + 2\{(1 - (VGS - VT)/Vp)^{3/2} - 1\}/3] \qquad (2)$$

$$K = \varepsilon\mu w/2dLg \qquad (3)$$

$$VT = Vbi - Vp \qquad (4)$$

$$Vp = d^2(qND/2\varepsilon) \qquad (5)$$

$$Vbi \geq VGS > VT \qquad (6)$$

where
    Id: the drain current
    VT: the threshold voltage of the FET
    VGS: the gate-source voltage
    ε: the dielectric constant of the semiconductor layer
  μ: the electron mobility
  w: the gate width
  d: the depth of the semiconductor layer
  Lg: the gate length
  ND: the donor concentration
  Vbi: the built-in voltage of the Schottky barrier.

As is apparent in inequality (6), the upper limit of the gate-source voltage is given as a voltage at which the current flowing in the gate cannot be neglected with reference to the drain current. The upper limit substantially corresponds to the built-in voltage $V_{bi}$ ($\sim \Phi_{BN}$). Therefore, the maximum value (i.e., maximum drain output current $I_{dmax}$) of the drain current is derived from equation (2) as:

$$I_{dmax} = 4kV_{bi}^2/3 \qquad (7)$$

when the absolute value of the threshold voltage $|V_T|$ is negligible with respect to the built-in voltage $V_{bi}$. The maximum drain output current $I_{dmax}$ is determined by the built-in voltage $V_{bi}$ in accordance with relation $I_{dmax} \propto V_{bi}^2$.

As described above, the Schottky barrier height $\Phi_{BN}$, that is, the built-in voltage $V_{bi}$ of the Schottky barrier in a nearly degenerated semiconductor, defines the upper limit of the gate-source voltage of the FET and hence the upper limit of the voltage swing of a logic FET. In addition, in the FET arranged in such a manner that the absolute value $|V_T|$ of the threshold voltage is negligible with respect to the built-in voltage $V_{bi}$, the built-in voltage $V_{bi}$ determines a maximum drain output voltage thereof in accordance with a squared value of $V_{bi}$. Therefore, the Schottky barrier height $\Phi_{BN}$ is one of the most important parameters of the MESFET. However, in the conventional GaAs FET, the Schottky barrier height $\Phi_{BN}$ has been controllable within the narrow range between 0.7 V and 0.85 V. Further, the maximum value of this height is not large enough. As a result, the Schottky barrier height $\Phi_{BN}$ can, in practice, be forcibly preset to be a predetermined constant without changing the type of the electronic metal.

The conventional GaAs MESFET has the following disadvantages due to the low Schottky barrier height $\Phi_{BN}$, even at the maximum of 0.85 V.

The upper limit of the gate-source voltage is set at a low voltage. A maximum drain output current of the FET having a small $|V_T|$ cannot be greatly increased.

In general, when a GaAs normally-off MESFET is used as an FET for driving a logic inverter, the upper limit of the signal voltage is set at the built-in voltage $V_{bi}$, so that upper and lower values $V_U$ and $V_L$ of the voltage of the circuit are given by the following inequality:

$$V_{bi} \geq V_U > V_T > V_L > 0 \qquad (8)$$

Therefore, when the conventional GaAs MESFET is used as a drive transistor, the upper limit of the logic voltage is set at the upper limit (0.85 V) of the built-in voltage. The allowable range of the threshold voltage which satisfies inequality (8) is narrow. As a result, the operating margin of the circuit is limited to a small value. In addition, a logic voltage amplitude $|V_U - V_L|$ cannot be widely preset, so the margin against external noise is also limited.

In general, in a MISFET IC using a silicon semiconductor, the principle of scaling down is applied to improve performance thereof and increase the packing density. In particular, when a scale factor representing a reduction ratio is given to be n, various parameters of the MISFET are multiplied by n, 1/n, 1/n² and so on. The potential parameters such as the power supply voltage $V_{DD}$, the logic voltage upper limit $V_U$, the logic voltage lower limit $V_L$, or the threshold voltage $V_T$ of the FET are multiplied by 1/n, thereby obtaining a miniaturized, highly integrated circuit. When the principle of scaling down is applied, a ratio of $V_{DD}:V_U:V_T:V_L$ must be kept constant. However, as previously described, the built-in voltage $V_{bi}$ is actually set to be a fixed value in the conventional GaAs MESFET, and cannot be increased. Therefore, the ratio of $V_{DD}:V_U:V_T:V_L$ is established only in accordance with the extremely limited power supply condition that $V_{DD} \leq V_{bi}$ ($< 0.85$ V). In this GaAs MESFET, the principle of scaling down can only be applied subject to the limitation described above, resulting in inconvenience.

The same drawback as in the conventional GaAs MESFETs described above exists also in the conventional $Ga_xAl_{1-x}As$ MESFETs. In particular, according to the conventional technique, the Schottky barrier height $\Phi_{BN}$ is variable only in the very narrow range such that

$$0.85 \text{ V} \leq \Phi_{BN} \leq 1.1 \text{ V} \leq 2 \text{ } (E_G'/q)/3,$$

where $E_G'$ is the energy gap of $Ga_xAl_{1-x}As$. Therefore, $Ga_xAl_{1-x}As$ has the same disadvantage as conventional GaAs.

In a conventional Si MESFET having a structure wherein a Schottky barrier junction gate metal is contacted to an n-type silicon semiconductor layer as an active layer, the gate metal generally comprises aluminum on account of an economic advantage thereof. The Schottky barrier height $\Phi_{BN}$ of the Al—Si junction falls within the range between 0.50 V and 0.59 V. Even if the Schottky barrier height $\Phi_{BN}$ is increased, on the basis of equation (1), by using a noble metal Pt having a very high work function $\Phi_M$, an actually measured value has an upper limit of about 0.85 V. In other words, in the conventional Si MESFET techniques, the Schottky barrier height $\Phi_{BN}$ can also be increased up to 0.76 times the energy gap ($E_G = 1.12$ eV) of the silicon. Therefore, the conventional Si MESFET techniques have the same difficulties as conventional GaAs MESFET techniques.

In an InP MESFET using an InP semiconductor layer as an active layer, it is difficult to form a Schottky barrier junction which satisfies required electrical characteristics such as the leakage current, the reverse breakdown voltage, and the stability.

In Japanese J. Appl. Phys. 21, 11, November 1982, pages 1559 to 1565, K. Murase et al report properties of chemically vapour-deposited amorphous silicon-germanium-boron alloy, including reference to its electrical contact properties with p on n⁺ and n on n⁺ epitaxial single-crystalline silicon.

It is a principal object of the present invention to provide an improved field effect transistor for an integrated circuit (IC).

It is another object of the present invention to provide a field effect transistor for an IC, wherein a gate junction barrier height ΦBN can be adjusted, in accordance with design conditions, to greater values than those obtainable for conventional metal-semiconductor junctions.

It is still another object of the present invention to provide a field effect transistor for an IC, wherein the operating margin of the IC for which the field effect transistor is larger than that of the conventional ICs using the conventional MESFETs.

It is still another object of the present invention to provide a field effect transistor for an IC, wherein margin against external noises also is larger compared with that of the conventional ICs using the conventional MESFETs.

It is still another object of the present invention to provide a field effect transistor for an IC, whereto the principle of scaling down can be applied.

It is still another object of the present invention to provide a field effect transistor for an IC, wherein the packing density of the IC is larger than that of the conventional ICs using the conventional MESFETs.

In order to achieve these objects of the present invention, an n-type semiconductor layer is used as an active layer;

a Schottky-barrier gate electrode is provided; and

source and drain electrodes are formed on portions of a major surface of said n-type semiconductor layer so that said gate electrode is between the source and drain electrodes;

the invention being characterized in that:

an amorphous silicon (to be referred to as an a—Si hereinafter) region is formed on a prospective gate region of said major surface of said n-type semiconductor layer;

said a—Si region contains boron (to be referred to as B hereinafter) in a concentration of about but more than 10 atom %; and

a metal layer is deposited on said a—Si region so as to constitute said gate electrode together with said a—Si region.

The a—Si layer may contain germanium (to be referred to as Ge hereinafter) in addition to the above stated B content.

Embodiments of the invention will now be described, by way of example, with reference to the accompanying drawings in which:—

Fig. 1 is a longitudinal sectional view of a field effect transistor (FET) for an IC according to an embodiment of the present invention;

Fig. 2 is a graph showing the relationship among the flow rate ratio

$$GeH_4/(SiH_4+GeH_4)$$

and the flow rate ratio

$$B_2H_6/(SiH_4+GeH_4)$$

and the junction barrier height;

Fig. 3 is a graph showing the relationship between the concentration of B contained in the a—Si film and the flow rate ratio

$$B_2H_6/(SiH_4+GeH_4),$$

with the flow rate ratio

$$GeH_4/(SiH_4+GeH_4)$$

as a parameter;

Fig. 4 is a graph showing the relationship between the flow rate of

$$B_2H_6/(SiH_4+GeH_4)$$

and the junction barrier height ΦBN';

Fig. 5 is a graph showing the relationship between the flow rate ratio

$$B_2H_6/(SiH_4+GeH_4)$$

and the resistivity of the a—Si film;

Fig. 6 is a graph showing the relationship between the built-in voltage Vbi of the FET and the relative value of the maximum drain current; and

Figs. 7 to 19 are longitudinal sectional views for explaining FETs for an IC according to other embodiments of the present invention.

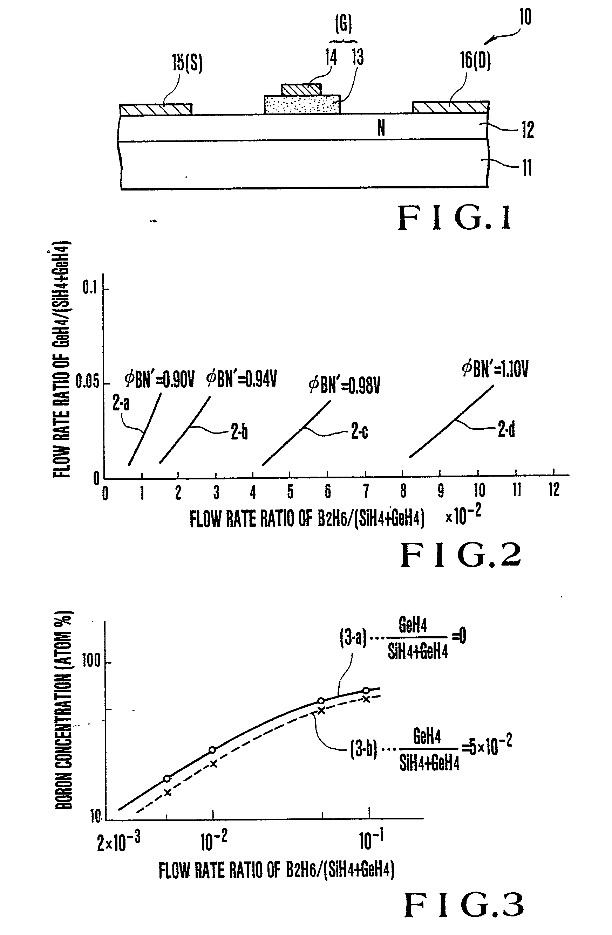

Fig. 1 shows a field effect transistor (FET) 10 for an IC according to an embodiment of the present invention. The transistor 10 has a GaAs semiconductor layer (i.e., compound semiconductor layer) 12 which contains n-type impurities of 1 to $5\times10^{17}$ cm$^{-3}$ concentration, which has a thickness of 100 nm (1,000 Å), and which is formed on or in a GaAs semi-insulating substrate 11 having a resistivity of $10^5$ Ω · cm or more, and an amorphous silicon (a—Si) region 13 which has a thickness of 1,500 Å and which is in direct contact with part of the surface of the GaAs semiconductor layer 12. A metal layer 14 made of Al or Ti or Mo or W or Pt is deposited on the a—Si region 13. The metal layer 14, together with the a—Si region 13, constitutes a gate electrode G. The FET 10 also has source and drain electrodes S and D which respectively comprise metal layers 15 and 16. The metal layers 15 and 16 are made of AuGe or InAg so as to constitute an alloy-type ohmic contact with the semiconductor layer 12 and are located with the a—Si region 13 in between. The presence of the a—Si region 13 is an important factor in preparing the FET of this embodiment. The a—Si region 13 typically contains 10 to 60 atom% of B, or Ge in addition to 10 to 60 atom% of B. By changing the concentration of B or Ge in a manner to be described later, the barrier height ΦBN' between the a—Si region 13 and the n-type GaAs semiconductor layer 12 can have values in a wider range and higher value. The above-stated concentration of B is necessary only in such a portion of the a—Si region 13 which has at least a thickness of 5 to 20 nm (50 to 200 Å) from the interface between the n-type GaAs semiconductor layer 12 and the a—Si region 13. This is because this thickness is sufficient for determining the barrier height $\Phi BN'$.

A process for fabricating the FET shown in Fig. 1 will be described hereinafter. An n-type GaAs semiconductor layer 12 is formed on or in a major surface of a GaAs semi-insulating substrate 11 having a resistivity of $10^5$ $\Omega \cdot$ cm or higher. The GaAs semiconductor layer 12 contains an n-type impurity at a concentration of 1 to $5 \times 10^{15}$ cm$^{-3}$ and has a thickness of 100 nm (1,000 Å). In this case, the semiconductor layer 12 is grown by a vapor-phase epitaxial growth method or a molecular beam epitaxial growth method. Alternatively, an n-type impurity such as $Si^+$, $S^+$ or $Se^+$ is ion-implanted in the GaAs semi-insulating substrate 11, thereby preparing the GaAs semiconductor layer 12. For example, $Si^+$ is ion-implanted in the GaAs semi-insulating substrate 11 at a desired dose and at an acceleration voltage of 60 keV. Thereafter, an $Si_3N_4$ film is grown by a vapor-phase growth method on the substrate 11 to a thickness of 150 nm (1,500 Å). The resultant structure is then annealed in an $N_2$ gas at a temperature of 800°C for 20 minutes, thereby recovering damage of the crystal lattice and electrically activating the doped impurity.

Subsequently, the a—Si region 13 is formed on the GaAs semiconductor layer 12 in the following manner, that is by chemical vapor deposition (CVD) method. The sample having the GaAs semiconductor layer 12 is placed in a reaction tube at a reaction temperature of 450°C. Material gases of $SiH_4$ and $B_2H_6$ or $SiH_4$, $B_2H_6$ and $GeH_4$ which are diluted by He are supplied to the reaction tube at a total gas pressure of 0.2 Torr (1 Torr=133.32 Pa) so as to form on the GaAs semiconductor layer 12 an a—Si film which contains boron in the neighbourhood of, and more than 10 atom%, or Ge in addition to the above atom% of B. Flow rates of gases described above are given to vary the gate junction barrier height $\Phi BN'$ as follows:

$GeH_4/(SiH_4+GeH_4)=0$ to $1 \times 10^{-1}$
$B_2H_6/(SiH_4+GeH_4)=1 \times 10^{-3}$ to $2 \times 10^{-1}$

A detailed description of gas flow control will be made later.

An unnecessary region (a region excluding a portion to be used as the gate electrode) of the a—Si film is removed by a known photolithography method and a known etching method such as plasma etching using, for example, $CF_4$ and $O_2$, thereby forming the a—Si region 13.

Aluminum or any other metal is deposited entirely or locally on the resultant structure and is patterned to prepare the metal layers 14, 15 and 16. In this case, the metal layers 14, 15 and 16 are formed such that the predetermined aluminum pattern is annealed in an $N_2$ gas at a temperature of 450°C for 20 seconds so as to provide a low-resistance ohmic contact.

The gate structure as the main feature of the present invention will be described. The gate structure comprises a combination of the a—Si region 13 which is disposed on the GaAs semiconductor layer 12 and which contains in the neighbourhood of, and more than 10 atom% of B, or Ge in addition to the above stated atom% of B, and the metal layer 14 formed on the a—Si region 13.

The present inventors found that electrical characteristics of a junction between the n-type GaAs semiconductor layer 12 and the a—Si region 13 which contains above stated atom% of B, or Ge in addition to the above stated atom% of B, coincided with the Schottky barrier characteristics or the so-called one-side-abrupt characteristics. We also found that the ideality factor of the current-voltage characteristics was from 1.0 to 1.3, indicating that the current-characteristics were very good.

Figure 2 shows a relationship between the gate junction barrier height $\Phi BN'$ obtained in accordance with the current-voltage characteristics between the a—Si region 13 and the n-type GaAs semiconductor layer 12, and the flow rate ratio of the material gases which is one of the parameters to be controlled for forming the a—Si film. In order to obtain a desired barrier height $\Phi BN'$ of the junction between the a—Si region 13 and the n-type GaAs semiconductor layer 12, the required flow rate ratios of $SiH_4$, $B_2H_6$ and $GeH_4$ can be determined in accordance with curves similar to the curves in Fig. 2. The curves 2—a, 2—b, 2—c and 2—d in Fig. 2 indicate the flow rate ratios, when values of the barrier height $\Phi BN'$ are to be 0.90 V, 0.94 V, 0.98 V and 1.10 V, respectively. For example, in order to set the barrier height $\Phi BN'$ to be 1.10 V, the flow rate ratios of

$$B_2H_6/(SiH_4+GeH_4)$$

and

$$GeH_4/(SiH_4+GeH_4)$$

are set to be, for example, about $8 \times 10^{-2}$ and $1 \times 10^{-2}$, respectively. Any other combinations of the flow rate ratios indicated by the curve 2-d are applicable.

Figure 3 shows the atom% of B in the a—Si film as a function of the flow rate ratio of

$$B_2H_6/(SiH_4+GeH_4),$$

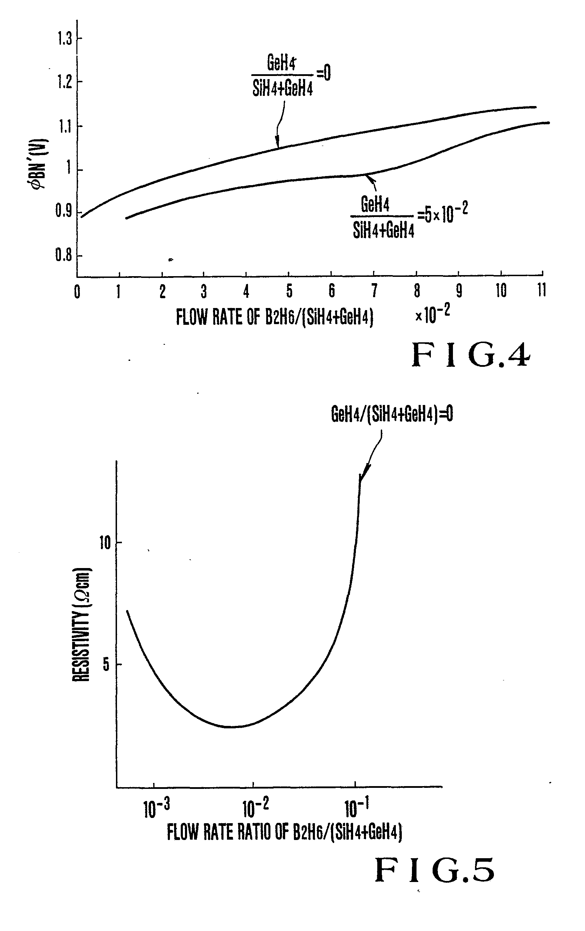

and Fig. 4 shows the barrier height $\Phi BN'$ of the junction between the a—Si film and the n-type GaAs semiconductor layer as a function of the flow rate ratio of

$$B_2H_6/(SiH_4+GeH_4).$$

In each of the graphs shown in Figs. 3 and 4, the flow rate ratio of

$$GeH_4/(SiH_4+GeH_4)$$

is used as a parameter. Curves 3-a and 4-a respectively indicate cases where the flow rate of $GeH_4$ is zero (i.e., where the a—Si film contains B but not Ge). Curves 3-b and 4-b respectively indicate cases where $SiH_4$, $B_2H_6$ and $GeH_4$ gases are used as the material gases and the flow rate ratio of

$$GeH_4/(SiH_4+GeH_4)$$

is given to be $5\times10^{-2}$ (i.e., where the resultant a—Si film contains both B and Ge). Fig. 3 indicates that the B concentration is increased when the flow rate ratio of

$$B_2H_6/(SiH_4+GeH_4)$$

gas is increased. Fig. 3 also indicates that the B concentration in the a—Si film does not greatly change in accordance with a change in flow rate ratio of

$$GeH_4/(SiH_4+GeH_4).$$

Fig. 4 indicates that the barrier height ΦBN' of the junction between the a—Si film and the n-type GaAs semiconductor layer is increased to within the range of about 0.90 V to 1.15 V when the flow rate ratio of

$$B_2H_6/(SiH_4+GeH_4)$$

is increased. When $GeH_4$ gas is supplied, the barrier height BN' is decreased in comparison with the case of the curve 4-a. According to this characteristic, it is readily understood that the barrier height ΦBN' changes in accordance with a change in the flow rate ratio of

$$GeH_4/(SiH_4+GeH_4).$$

It is also understood that the B concentration should be at least 10 atom% in the a—Si region 13 in order to set the barrier height ΦBN' to be 0.85 V or higher, which cannot be achieved by the conventional Schottky barrier junctions. For example, as is apparent from the curve 2-a in Fig. 2, in order to obtain the barrier height ΦBN' of 0.90 V or higher when the flow rate ratio of

$$GeH_4/(SiH_4+GeH_4)$$

is set to be zero (i.e., when $GeH_4$ gas is not supplied), the flow rate ratio of

$$B_2H_6/(SiH_4+GeH_4)$$

must be set to be about $5\times10^{-3}$ or higher. In this case, as is apparent from the curve 3-a in Fig. 3, the resultant a—Si film contains at least about 15 atom% of B. Although not illustrated in Figs. 2 and 4, the flow rate ratio curves for obtaining a barrier height ΦBN' of 0.85 V, which is equivalent to the maximum value of the conventional Schottky barrier height ΦBN, lie to the left of curves 2-a and 4-a, respectively. These conditions can be achieved with a reduced flow rate ratio of

$$B_2H_6/(SiH_4+GeH_4),$$

compared to the cases for the curves 2-a and 4-a. In this case, the resultant a—Si film contains B to about 10 atom%. Therefore, in order to obtain a larger barrier height ΦBN' than the maximum value of the conventional Schottky barrier height ΦBN, the B concentration in the a—Si film must be higher than at least 10 atom%.

In the above embodiment, a—Si containing at least 10 atom% of B, or a—Si containing Ge and at least 10 atom% of B, constitutes the a—Si region 13. When a—Si containing Ge in addition to B is used, the electric resistance of the a—Si region 13 can be decreased.

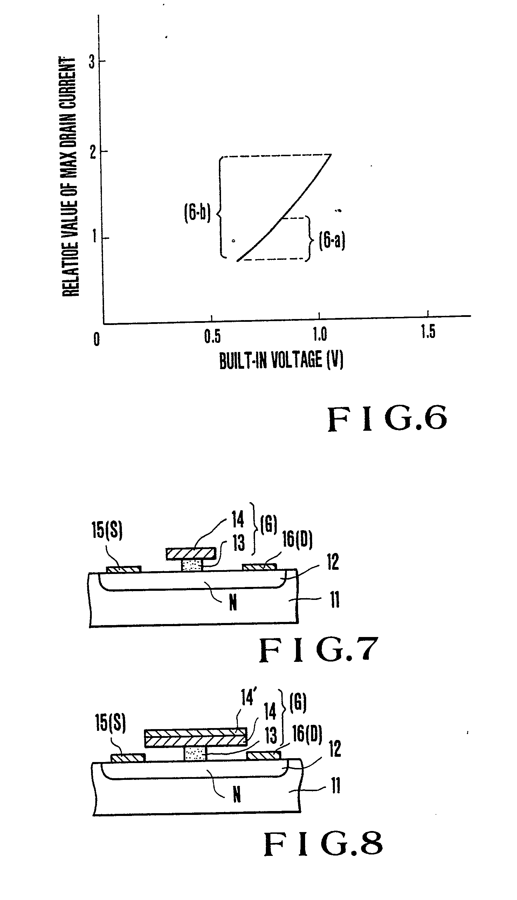

The upper limit of the B concentration in the a—Si region 13 will now be considered. As is apparent from the characteristics shown in Fig. 4, the barrier height ΦBN' saturates, when

$$B_2H_6/(SiH_4+GeH_4)$$

is more than about $1\times10^{-1}$. Now consider the characteristic curve shown in Fig. 5. Figure 5 shows the relationship between the resistivity of the a—Si film and the flow rate ratio of

$$B_2H_6/(SiH_4+GeH_4)$$

when the flow rate ratio of

$$GeH_4/(SiH_4+GeH_4)$$

is set to be zero. When the flow rate ratio of

$$B_2H_6/(SiH_4+GeH_4)$$

increases exceeding about $1\times10^{-2}$, the resistivity increases at an accelerating rate. When the resistivity becomes about 10 Ω·cm or higher, the a—Si region 13 combined with the metal layer 14 will not serve as a good electrode. Therefore, the B concentration in the a—Si film must have an upper limit of about 60 atom%, as confirmed from Fig. 3.

It should be noted that the metal layer is deposited on the a—Si film to provide a practical gate electrode with a low resistivity. For example, when the gate electrode comprises only a—Si and has a length Lg, a width W and a thickness T, its electric resistance is given to be pW/(LgT) where ρ is the resistivity of a—Si. The minimum resistivity of a—Si is given to be about 1 Ω·cm. When the length Lg, the width W and the thickness T are given, for example, to be 1 μm, 10 μm and 150 nm (1,500 Å) respectively, the electric resistance of the gate electrode becomes very high, up to about 670 kΩ, and becomes impractical. The upper limit of the electric resistance varies in accordance with the specifications of the target circuit. However, the electric resistance of the gate electrode having the length Lg and the width W is preferably less than about 1 kΩ. On the other hand, when the metal layer is deposited on the a—Si film, the electric resistance of the gate electrode is given by ρT/(LgW) and becomes as low as 0.15 kΩ. The resistivity of a—Si becomes 10 Ω · cm or higher in accordance with the composition of a—Si. However, the thickness T can be as small as 5—20 nm (50 to 200 Å) without problem, as previously described. Therefore, the electric resistance of the gate electrode can be decreased to be less than 1 kΩ by decreasing the thickness T.

According to this embodiment as previously described, a barrier junction similar to the conventional Schottky barrier junctions can be obtained. In addition, as is apparent from Fig. 2, when the B concentration in the a—Si film is properly preset (i.e., when the flow rate ratios of the material gases are properly preset), the range of the barrier height ΦBN′ can be widened compared with that of the conventional FETs. Furthermore, the upper limit (1.15 V) of the potential difference becomes higher by 0.3 V than that of the conventional potential difference. Although not illustrated in Fig. 2, the Schottky barrier height ΦBN obtained using conventional metal can also be obtained using the a—Si film according to the present invention by changing the B concentration thereof.

The electronic structure of the a—Si region containing B, which is used in the present invention, and gives a wide range of the barrier height ΦBN′, will be considered. The electronic structure of this region is the same as that of a metal, except that electron states are spatially localized. In other words, highly dense localized electron states are present in an energy region (width of 2 eV or more) which includes the Fermi level. The localized electron state density at the Fermi level amounts to the order of $10^{19}$ cm$^{-3}$ · eV$^{-1}$ or $10^{20}$ cm$^{-3}$ · eV$^{-1}$, as confirmed from both electrical and optical properties of the present a—Si. A part of the localized electron states are due to dangling bonds. However, the dangling bond density is very low being of the order of $10^{17}$ cm$^{-3}$ · eV$^{-1}$ or less, as confirmed from the results of ESR measurement. The other part or almost all the part of the localized electron states are due to Anderson localization. This situation of the localized electron states is one of the characteristic features of the present a—Si which distinguish it from the conventional a—Si. Since the high-density localized electron states of the order of $10^{19}$ to $10^{20}$ cm$^{-3}$ · eV$^{-1}$ are present in the wide energy region containing the Fermi level, it is considered that electric conduction at room temperature and even at such a high temperature as 200°C is due to a hopping mechanism. This is another characteristic feature of the present a—Si which distinguishes it from the conventional a—Si.

In order to clearly distinguish the present a—Si from the conventional a—Si, properties of the conventional a—Si are described in detail in the following. In conventional a—Si such as a—Si containing hydrogen or fluorine but excluding an acceptor impurity such as boron and a donor impurity such as phosphorus, the localized electron states occurring in the vicinity of the Fermi level are mainly caused by dangling bonding, and not by Anderson localization. The localized electron state density at the Fermi level varies in accordance with the content and bonding state of hydrogen and/or fluorine and is generally of the order of $10^{16}$ cm$^{-3}$ · eV$^{-1}$ to $10^{17}$ cm$^{-3}$ · eV$^{-1}$. Electric conduction at room temperature or higher temperature is constructed by band conduction by means of carriers in the valence band and/or conduction band.

In conventional a—Si containing an acceptor (e.g., boron) or donor (e.g., phosphorus) impurity in addition to hydrogen or fluorine, the Fermi level can be situated in the energy region in which electron states are localized in accordance with Anderson localization. However, the width of this energy region is at most 0.5 eV. Electric conduction of the conventional a—Si containing an acceptor or donor at room temperature or higher is the same as in conventional a—Si which does not contain the acceptor or donor impurity.

In conventional a—Si which contains neither hydrogen nor fluorine, the Fermi level is included in the energy region in which the electron states are localized. However, these localized electron states are mainly caused by dangling bonds. In this case, the dangling bonding density can be as high as of the order of $10^{19}$ to $10^{20}$ cm$^{-3}$. In addition, the width of this energy region is at most 1.9 eV.

As is apparent from the above description, the present invention has an advantage in that the gate junction barrier height ΦBN′ can be in a wider range and higher value than the conventional Schottky barrier potential difference ΦBN. In association with this main feature of the present invention, various effects can be obtained as follows.

First, a gate-source voltage can be increased up to a maximum of 1.15 V.

Second, a maximum drain output current range can be doubled as compared with the range of the conventional FET. This will be explained in more detail in the following.

In general, the FET is operated in such a manner that the drain or source current is used as the output signal while the voltage applied to the gate electrode G is the input signal.

Fig. 6 shows the relationship between the built-in voltage Vbi of the gate junction and the relative value of the maximum drain current which can be extracted from the drain electrode D while a predetermined biasing voltage is applied between the source electrode S and the drain electrode D of the FET shown in Fig. 1, and a maximum gate voltage is applied to the gate electrode G. The electrical characteristics of the GaAs FET of the present invention and the conventional GaAs MESFET are illustrated for comparison. The relationship in Fig. 6 is obtained, when the built-in voltage Vbi is varied in the FET so arranged that the threshold voltage VT is 0, a typical case for the logic FET. In order to keep the threshold voltage VT constant (in this case zero) while the built-in voltage Vbi is changed, an impurity concentration ND of the n-type GaAs semiconductor layer 12 must be changed so as to satisfy the following equation, as is apparent from equations (4) and (5):

$$ND=(2\varepsilon/q) \cdot (Vbi/d^2) \qquad (9)$$

Referring to Fig. 6, a curve 6-a indicates the range of the relative value of the maximum drain current obtainable by changing the metal material of the gate electrode in the conventional GaAs MESFETs, while a curve 6-b indicates the range of the relative value of the maximum drain current obtained by changing the B and/or Ge concentration in the a—Si region 13. According to the FET of this embodiment, the maximum drain current Idmax can be doubled as compared with that of the conventional FET.

Third, along with the effect wherein the upper limit of the gate input voltage can be set at a high voltage, performance of the GaAs normally-off logic circuit can be greatly improved. As described with reference to the conventional technique, the upper and lower values VU and VL of the FET logic voltage are given by the following inequality:

$$Vbi \geq VU > VT > VL > 0 \qquad (8)$$

The upper limit VU of the conventional FET is at most 0.85 V. However, since the built-in voltage Vbi of the gate junction of the present invention can be set at a higher voltage than that of the conventional FET, the upper limit VU of the FET of this embodiment is increased by a maximum of about 0.3 V. As a result, the allowable range of both the threshold voltage to be preset in a predetermined circuit so as to satisfy the condition given by inequality equation (8) and the scattering of the threshold voltage can be increased. Therefore, the operating margin of the circuit can greatly be increased. In addition to this advantage, the logic voltage amplitude |VU−VL| can be increased, so that the margin against external noise can also be increased.

Fourth, since the range of the built-in voltage Vbi of the gate junction can be widened by changing the concentration of B and/or Ge contained in the a—Si region 13, the principle of scaling down used for improving performance of the Si MISFET can also be applied to a variety of FETs. In particular, in the conventional GaAs MESFET, the built-in voltage Vbi is actually fixed at a low value, as previously described. When the principle of scaling down is applied, the ratio of VDD:VU:VT:VL is given only under the condition VDD≤Vbi. In this manner, the application of the principle of scaling down is limited.

On the other hand, in the FET of the present invention, since the built-in voltage Vbi of the gate junction can be set to be a wider range and a higher value, the principle of scaling down can be applied in accordance with this wider range.

Fifth, the packing density of the FET can be increased. As previously described, the FET according to the present invention has a higher built-in voltage Vbi of the gate junction, so that the maximum drain current Idmax can be doubled at maximum as compared with that of the conventional GaAs MESFET, when the same gate width and the same gate length are used, as shown in Fig. 6. If the same output current is used as in the conventional FET, the gate width of the FET of this embodiment can be decreased, thereby increasing the packing density thereof.

In addition, the present invention has the following advantages in the fabrication process.

A metal such as Pt or Au which provides a high Schottky barrier height ΦBN of the conventional FET has a high resistance to chemicals, so that the gate pattern of this metal must be defined by the lift-off method. However, the lift-off method has poor reliability and is not suitable for fabrication of an LSI. Conversely, the a—Si film used in the present invention can be easily etched by plasma etching.

Furthermore, Pt used for forming the conventional Schottky barrier junction reacts with GaAs at temperatures above 200~300°C, and the threshold voltage of the resultant FET greatly changes. Similarly, Au is subjected to diffusion at temperatures above 200°C, and the barrier height ΦBN is decreased. Conversely, the a—Si film used in the present invention is formed at a temperature of about 450°C or higher and has a property of high thermal stability as compared with that of Pt or Au, thereby providing high reliability.

Furthermore, on account of poor thermal resistance of the Schottky barrier junction obtained using a metal providing high barrier heights ΦBN, severe restrictions are imposed on the manufacturing process (e.g., regarding the order of manufacturing steps, and the materials to be used) after the Schottky barrier is formed. Conversely, when the a—Si film according to the present invention is used, such restrictions can substantially be eliminated.

The above description has been made with reference to the first embodiment using the n-type GaAs semiconductor layer. Other embodiments can also be realized for the present invention.

A second embodiment provides an FET which has an n-type $Ga_xAl_{1-x}As$ semiconductor layer in place of the n-type GaAs semiconductor layer of the first embodiment. In this case, the n-type $Ga_xAl_{1-x}As$ semiconductor layer is formed on a $Ga_xAl_{1-x}As$ semi-insulating substrate.

A third embodiment provides an FET which has an n-type Si semiconductor layer in place of the n-type GaAs semiconductor layer of the first embodiment. In this case, the n-type Si layer is formed on a sapphire or on or in p⁻-type silicon substrate. When the n-type silicon semiconductor layer is used and an a—Si film is formed thereon, the deposition temperature of the a—Si film can be higher than that in the embodiment using GaAs or $Ga_xAl_{1-x}As$, because the n-type silicon is free from such a problem as thermal dissociation of arsenic (As) on the surface of GaAs or $Ga_xAl_{1-x}As$.

In either of the second and third embodiments, when an a—Si region containing about but more than 10 atom% of B, or an a—Si region containing Ge and the above stated atom% of B, is used, the gate junction barrier height $\Phi BN'$ can have a wider range and a higher value. Therefore, the same effects as in the first embodiment can be obtained in the second and third embodiments.

A fourth embodiment provides an FET which has an n-type InP semiconductor layer in place of the n-type GaAs semiconductor layer. The InP FET realized in accordance with this invention the above-mentioned advantages. In particular, it should be noted that the InP FET in accordance with this invention has a stable gate junction the characteristics of which resembles those of good Schottky barrier junctions, although such a stable junction cannot be obtained by conventional FET techniques. In the fourth embodiment, a semi-insulating InP substrate is used.

A fifth embodiment provides an FET having an acceptor-doped a—Si region wherein an acceptor impurity has an ionization energy of 0.1 V or less with respect to an n-type semiconductor layer which serves as an active layer. The a—Si region, which contains boron in the concentration of about but more than 10 atom%, or Ge in addition to the above atom% of B, is prepared such that an acceptor impurity element is mixed in the material gases used in the manufacture of the FET of Fig. 1. The resultant a—Si film contains a p-type impurity element as follows: Be, Zn or the like for GaAs or $Ga_xAl_{1-x}As$; B, Ga or the like for Si; and Be, Zn or the like for InP. This acceptor impurity element constitutes a shallow level localized only on the very limited surface portion of the semiconductor layer at an interface between the a—Si region and the n-type semiconductor layer. Therefore, the Fermi level can be shifted to near the valence band. As a result, the range of the barrier height $\Phi BN'$ can become wider than that of the first embodiment. A greater effect can thus be obtained.

The various embodiments based on the descriptions above will be briefly described with reference to Figs. 7 to 19. The same reference numerals denote the same parts throughout Figs. 7 to 19, and a detailed description thereof will be omitted.

Figs. 7 to 16 show embodiments wherein n-type GaAs semiconductor layers serve as active layers.

The FET shown in Fig. 7 is substantially the same as that in Fig. 1, except that a width of an a—Si region 13 formed on the surface of an n-type semiconductor layer 12 is particularly narrowed, and that a gate length is shorter than that in Fig. 1. In the FET in Fig. 7, after a metal layer 14 is formed so as to constitute a gate electrode G together with the a—Si region 13, the side walls of the a—Si region 13 are etched by plasma etching using an etchant of $CF_4$ and $O_2$ at a proper etching rate. In the structure of the FET in Fig. 7, a high-melting metal such as Mo or W is preferably used for the metal layer 14 so as to prevent deformation of the metal layer when a source electrode S and a drain electrode D are partially alloyed at a temperture of 350°C to 500°C.

The FET shown in Fig. 8 substantially resembles that in Fig. 7 and has a feature wherein a source electrode S and a drain electrode D are self-aligned with respect to a gate electrode G, and a metal layer 14' is deposited on a metal layer 14. In this case, the metal layer 14' is not always necessary to constitute the gate electrode. However, the metal layer 14' is automatically deposited when a source electrode 15 and a drain electrode 16 are formed in a self-aligned manner with respect to the gate electrode. The metal layer 14' need not be removed, so it can be left. In order to manufacture the FET in Fig. 8, an ohmic metal layer is deposited to cover the entire surface of a structure before the source electrode S and the drain electrode D of the FET of Fig. 7 are formed. Thereafter, a photoresist pattern is formed to cover the source electrode S, the drain electrode D and the gate electrode G, and an exposed portion of the metal layer is etched by ion milling or the like. The photoresist pattern is then removed, and alloying of the metal layer to provide an ohmic contact is performed.

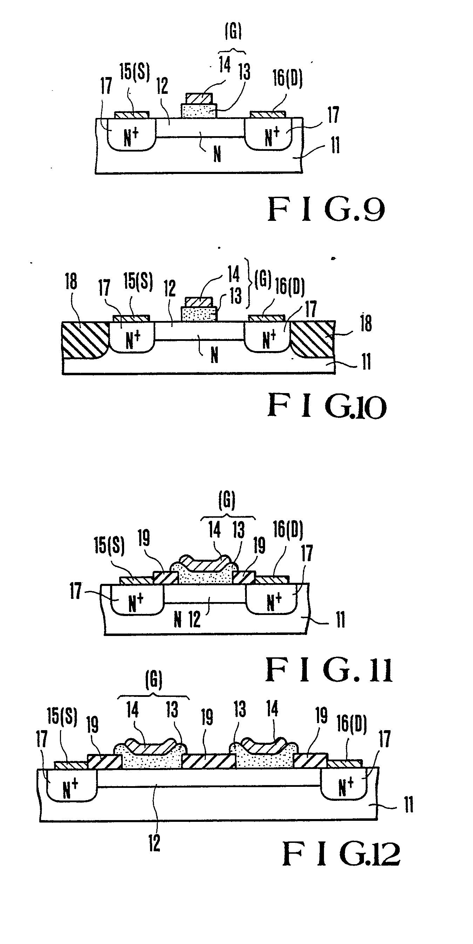

The FET shown in Fig. 9 substantially resembles that in Fig. 7 and has a feature wherein $n^+$-type regions 17 are formed around an n-type GaAs semiconductor layer or region 12 underlying an a—Si region 13 so as to correspond to a source electrode S and a drain electrode D. The $n^+$-type regions 17 are formed such that n-type impurities are doped or ion-implanted at a high concentration through a mask which has openings respectively corresponding to the source and drain electrodes S and D. More specifically, $Si^+$ ions are selectively ion-implanted in predetermined regions (prospective source and drain electrode regions) of the n-type semiconductor layer 12 at a dose of $2 \times 10^{13}$ $cm^{-2}$ or more and at an acceleration voltage of 100 keV. Thereafter, an $Si_3N_4$ film is deposited by the chemical vapor deposition (CVD) method to a thickness of about 150 nm (1,500 Å), and the resultant structure is annealed at a temperature of 800°C for 20 minutes, thereby forming the $n^+$-type regions 17 each of which has a peak impurity concentration of the order of $10^{18}$ $cm^{-3}$. Thereafter, the $Si_3N_4$ film is removed by a known etching method such as plasma etching to expose the surface of the n-type GaAs semiconductor layer 12. The subsequent process is the same as that in Fig. 1, thereby preparing the FET shown in Fig. 9.

The FET shown in Fig. 10 substantially resembles that in Fig. 9 and has a feature wherein an insulating region (guard ring) 18 is formed to isolate the FET from other FETs formed outside this element formation region. The insulating region 18 is formed by ion-implanting such ions as oxygen, proton and chrominium. For example, oxygen ions are implanted in the substrate 11 at an acceleration voltage of 100 to 300 keV. In this case, a prospective FET formation region is covered with a resist film of 0.5 to 5 μm thickness or a combination of a resist film and an $SiO_2$ film or $Si_3N_4$ film, thereby preventing damaging of the FET at the time of implanting.

The FET shown in Fig. 11 substantially resembles that in Fig. 10 and has a feature wherein an insulating film 19 such as an $SiO_2$ or $Si_3N_4$ film is formed on an n-type semiconductor layer between an a—Si region 13 and a source electrode S and between the a—Si region 13 and a drain electrode D.

The FET shown in Fig. 12 substantially resembles that in Fig. 11 and has a feature wherein a plurality of gate structures and gate electrodes are formed. The multi-gate FET serves as an inverter wherein independent input signals are supplied to the respective gate electrodes G so as to generate an inverter output by means of logic OR of multiple inputs in the same manner as in a single gate FET. The feature and effects of this FET are the same as those of other FETs of the present invention, except that the logic OR function is added.

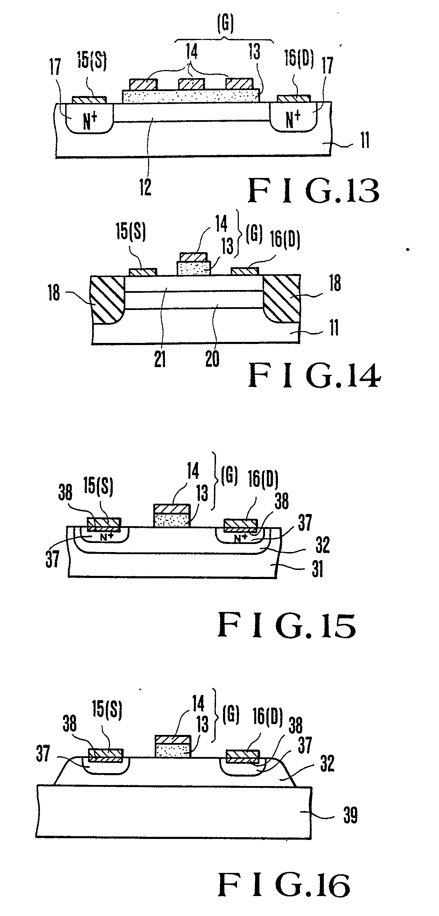

The FET shown in Fig. 13 substantially resembles that in Fig. 9 and has a feature wherein metal layers 14 of the gate electrode G are deposited on an a—Si region 13. The function of this FET is the same as that in Fig. 12. In the FET in Fig. 13, the thickness of the a—Si region 13 is extremely reduced, and a high electric resistance must be provided such that potential differences between the metal layers 14 of the gate electrode G can be maintained. For example, since the resistivity of a—Si is set to be higher than about $1 \, \Omega \cdot cm$ as shown in Fig. 5, the electrical resistance between two metal layers and the a—Si region 13 can be set to be 1 MΩ or higher under the conditions that the thickness of the a—Si region 13 is set to be 50 Å or less and the two metal layers each having a junction gate width of 10 μm are spaced apart from each other by 5 μm or more.

Fig. 14 shows an FET wherein two semiconductor layers serve as active layers, and which have a heterojunction in between. This FET has a high-purity low-impurity-concentration (of the order of $10^{15} \, cm^{-3}$) semiconductor layer 20, for example, comprising GaAs, which is formed on a GaAs semi-insulating substrate 11. An n+-type semiconductor layer 21, for example, comprising $Ga_xAl_{1-x}As$ which constitutes the heterojunction is formed on the semiconductor layer 20. An a—Si region 13, a source electrode S and a drain electrode D are formed on the n+-type $Ga_xAl_{1-x}As$ semiconductor layer 21. A metal layer 14 which, together with the a—Si region 13 constitutes a gate electrode G, is formed on the a—Si region 13. The FET in Fig. 14 has an insulating region 18 for electrically isolating the GaAs semiconductor layer 20 and the n+-type $Ga_xAl_{1-x}As$ semiconductor layer 21 from other FETs formed outside the insulating region 18. The GaAs semiconductor layer 20 and the n+-type $Ga_xAl_{1-x}As$ semiconductor

tor layer 21 which constitute the heterojunction are used as active layers. In this FET configuration, conduction electrons are generated in a portion of the GaAs semiconductor layer 21 which is located in the vicinity of the heterojunction interface.

In association with the description of the FET of Fig. 1, n-type $Ga_xAl_{1-x}As$ and InP are used as n-type semiconductor layers serving as the active layers in the second and fourth embodiments, respectively. The same applies to the FETs shown in Figs. 7 to 13. In these cases, semi-insulating $Ga_xAl_{1-x}As$ and InP substrates are used as the substrates 11, and n-type $Ga_xAl_{1-x}As$ and InP layers are used as the n-type semiconductor layers 12, respectively.

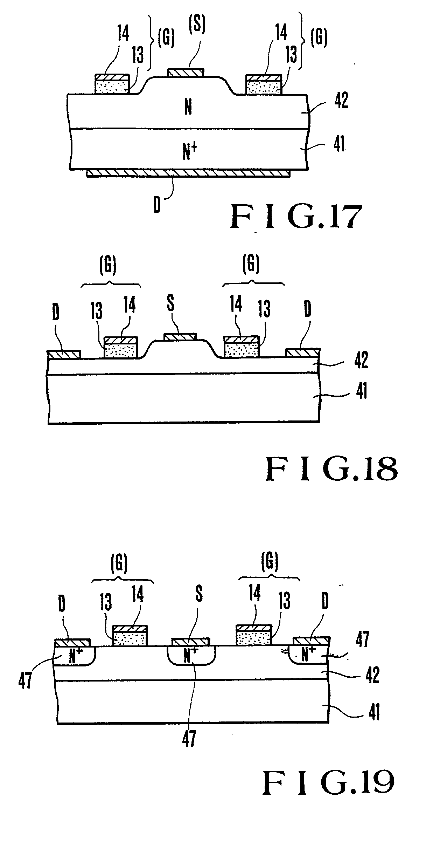

Figs. 15 and 16 show embodiments wherein n-type Si semiconductor layers are used as n-type semiconductor layers, respectively.

In the FET shown in Fig. 15, an n-type silicon layer 32 serving as an active layer is formed in a p−-type silicon substrate 31 having a resistivity of $100 \, \Omega \cdot cm$. N+-type regions 37 are formed in the n-type silicon layer 32 and correspond to source and drain, respectively. A Pt source electrode S and a Pt drain electrode D are deposited on the n+-type regions 37. Pt-Si regions 38 are formed underneath the source and drain electrodes S and D, respectively. For the source and drain electrodes, any other metal can be used. An a—Si region 13 is formed on a portion of the n-type silicon layer 32 which is located between the n+-type regions 37. The a—Si region 13 contains boron in the neighbourhood of, and more than 10 atom%, or Ge and the above stated atom% of B. In order to manufacture the FET shown in Fig. 15, phosphorus ions are ion-implanted in the silicon substrate, for example, at a dose of $1.4 \times 10^{12} \, cm^{-2}$ and at an acceleration voltage of 80 keV. The resultant structure is then annealed at a temperature of 800°C for 30 minutes to obtain the n-type silicon layer 32. An n-type impurity such as phosphorus is selectively diffused in the n-type silicon layer 32 to obtain the n+-type regions 37. The a—Si region 13 is formed at a predetermined position of the structure, and Pt is deposited on the n+-type regions 37 to a thickness of 200 to 300 nm (2,000 to 3,000 Å). The resultant structure is annealed at a temperature of 450°C for 30 minutes to obtain ohmic contact. Upon annealing, the Pt-Si regions 38 are also formed.

The FET shown in Fig. 16 substantially resembles that in Fig. 15 and has a feature wherein a sapphire substrate 39 is used in place of the p−-type silicon substrate 31, and an epitaxial layer grown on the sapphire substrate 39 is used as the n-type semiconductor layer 32.

The FET shown in Fig. 17 has an n-type silicon layer 42 of a mesa structure which is formed on an n+-type silicon substrate 41. A source electrode S is deposited on a top surface of the mesa structure. This FET has a—Si regions 13 on the lower-level surface portions of the mesa structure of the silicon layer 42. Each a—Si region 13 contains boron in the neighbourhood of, and more than 10 atom%, or Ge and the above stated atom% of B. A drain electrode D is formed on the bottom surface of the n⁺-type semiconductor substrate 41.

The FET shown in Fig. 18 substantially resembles that in Fig. 17 and has a feature wherein a drain electrode D is not formed on the bottom surface of a substrate 41, but drain electrodes D are formed at outer sides of a—Si regions 13.

The electrode arrangement of the FET shown in Fig. 19 substantially resembles that in Fig. 18 and has a feature wherein an n-type semiconductor layer 42 does not have a mesa structure, and n⁺-type regions 47 are respectively formed under source and drain electrodes S and D.

In the FETs in Figs. 18 and 19, a semi-insulating GaAs substrate is used as the substrate 41 when GaAs is used as the n-type semiconductor layer 42. When a silicon layer is used as the n-type semiconductor layer 42, a sapphire or p⁻-type silicon substrate is used.

The same effects as previously described can be obtained in the embodiments shown in Figs. 7 to 19.

## Claims

1. A field effect transistor for integrated circuits, comprising:
   an n-type semiconductor layer (12);
   a Schottky barrier gate electrode (G); and
   source and drain electrodes (S, D) formed on portions of a major surface of said n-type semiconductor layer (12) so that said gate electrode (G) is between the source and drain electrodes; characterized in that:
   an amorphous silicon region (13) is formed on a prospective gate region of said major surface of said n-type semiconductor layer (12);
   said amorphous silicon region contains boron in a concentration of about but more than 10 atom%; and
   a metal layer (14) is deposited on said amorphous silicon region (13) so as to constitute said gate electrode (G) together with said amorphous silicon region (13).

2. A transistor according to claim 1, characterized in that said amorphous silicon region (13) has a particular electronic structure which has localized electron states mainly caused by Anderson localization in an energy region including the Fermi level, said localized electron state density at the Fermi level is higher than the order 10¹⁹ cm⁻³ · eV⁻¹, and the width of said energy region is more than 2 eV.

3. A transistor according to claim 1 or claim 2, characterized in that said amorphous silicon region (13) is formed by a CVD method.

4. A transistor according to any one of claims 1 to 3, characterized in that said n-type semiconductor layer (12) comprises a compound semiconductor layer (12) which is formed on a semi-insulating substrate (11).

5. A transistor according to claim 4, characterized in that said compound semiconductor layer (12) and said semi-insulating substrate (11) are made of one material selected from the group consisting of GaAs, Ga$_x$Al$_{1-x}$As and InP.

6. A transistor according to any one of claims 1 to 3 characterized in that said n-type semiconductor layer (12) comprises a monocristalline silicon layer which is formed on an insulating substrate or on a p-type silicon substrate or in a p-type silicon substrate.

7. A transistor according to any one of claims 1 to 6 characterized in that said amorphous silicon region (13) contains germanium in addition to said boron content.

8. A transistor according to any one of claims 1 to 7 characterized in that said amorphous silicon region (13) further contains an element serving as a p-type impurity with respect to said n-type semiconductor layer.

9. A field effect transistor for integrated circuits, comprising:
   a semi-insulating substrate; a high-purity semiconductor layer on said semi-insulating substrate;
   an n-type semiconductor layer (12) formed on top of said high-purity semiconductor layer so as to constitute a heterojunction therewith;
   a Schottky barrier gate electrode (G); and
   source and drain electrodes (S, D) deposited on portions of a major surface of said n-type semiconductor layer (12) so that said gate electrode (G) is between the source and drain electrodes; characterized in that:
   an amorphous silicon region (13) is formed on part of said major surface of said n-type semiconductor layer;
   said amorphous silicon region contains boron in the neighbourhood of, and more than, 10 atom%, and
   a metal layer (14) is formed on said amorphous silicon region (13) so as to constitute said gate electrode (G) together with said amorphous silicon region (13).

10. A transistor according to claim 9 characterized in that said amorphous silicon region (13) further contains germanium in addition to said boron content.

11. A transistor according to claim 9 or claim 10, characterized in that said amorphous silicon region (13) further contains an element serving as a p-type impurity with respect to said n-type semiconductor layer.

12. A field effect transistor for integrated circuits, comprising:
   an n⁺-type silicon substrate;
   an n-type silicon layer (12) formed on said n⁺-type silicon substrate;
   a plurality of Schottky barrier gate electrodes (G);
   a source electrode (S) formed at a portion of one major surface of said n-type silicon layer (12) which is located between said gate electrodes (G); and
   a drain electrode (D) formed on the other major surface of said n⁺-type silicon substrate which is not in contact with said n-type silicon layer;

characterized in that:

amorphous silicon regions (13) are formed on said one major surface of said n-type silicon layer;

said amorphous silicon regions contain boron in the neighbourhood, and more than 10 atom%; and

said plurality of Schottky-barrier gate electrodes (G) are respectively formed on said amorphous silicon regions (13) and constitute a gate structure together with said amorphous silicon regions.

13. A transistor according to claim 12 characterized in that said amorphous silicon regions (13) further contain germanium in addition to said boron content.

14. A transistor according to claim 12 or claim 13 characterized in that said amorphous silicon regions (13) further contain an element serving as a p-type impurity with respect to said n-type semiconductor layer.

**Patentansprüche**

1. Ein Feldeffekt-Transistor für integrierte Schaltungen, umfassend
— eine Halbleiterschicht (12) vom n-Typ,
— eine Schottky-Barriere-Gate-Elektrode (G) und
— Source- und Drain-Elektroden (S, D), die auf Teilen einer Hauptfläche der n-Typ-Halbleiterschicht (12) gebildet sind, so daß sich die Gate-Elektrode (G) zwischen den Source- und Drain-Elektroden befindet, dadurch gekennzeichnet, daß
— eine amorphe Silizium-Zone (13) auf einer künftigen (beabsichtigten) Gate-Zone der Hauptfläche der n-Typ-Halbleiterschicht (12) ausgebildet ist;
— die Zone aus amorphem Silizium Bor in einer Konzentration von ungefähr, aber mehr als 10 Atom% enthält;
— eine Metallschicht (14) auf der amorphen Silizium-Zone (13) abgelagert ist, um die Gate-Elektrode (G) zusammen mit der amorphen Silizium-Zone (13) zu bilden.

2. Ein Transistor nach Anspruch 1, dadurch gekennzeichnet, daß die amorphe Silizium-Zone (13) eine besondere elektronische Struktur aufweist, die lokalisierte Elektronen-Zustände, hauptsächlich verursacht durch Anderson-Lokalisierung in einer das Fermi-Niveau einschließenden Energie-Zone, hat die lokalisierte Elektronenzustand-Dichte auf Fermi-Niveau höher ist als die Größenordnung $10^{19}$ cm$^{-3}$ · eV$^{-1}$ und die Breite der Energie-Zone mehr als 2 eV beträgt.

3. Ein Transistor nach dem Anspruch 1 oder Anspruch 2, dadurch gekennzeichnet, daß die amorphe Silizium-Zone (13) durch ein chemisches Aufdampfverfahren (CVD-Verfahren) gebildet ist.

4. Ein Transistor nach einem der Ansprüche 1 bis 3, dadurch gekennzeichnet, daß die n-Typ-Halbleiterschicht (12) eine Verbindungshalbleiter-Schicht (12) umfaßt, die auf einem halb-isolierenden Substrat ausgebildet ist.

5. Ein Transistor nach Anspruch 4, dadurch gekennzeichnet, daß die Verbindungshalbleiter-Schicht (12) und das halb-isolierende Substrat (11) aus einem Material hergestellt sind, das aus der Gruppe ausgewählt ist, die aus GaAS, Ga$_x$Al$_{1-x}$AS und InP besteht.

6. Ein Transistor nach einem der Ansprüche 1 bis 3, dadurch gekennzeichnet, daß die n-Typ-Halbleiterschicht (12) eine monokristalline Silizium-Schicht umfaßt, die auf einem isolierenden Substrat oder auf einem p-Typ-Silizium-Substrat oder in einem p-Typ Silizium-Substrat gebildet ist.

7. Ein Transistor nach einem der Ansprüche 1 bis 6, dadurch gekennzeichnet, daß die amorphe Silizium-Zone (13) zusätzlich zu dem Bor-Gehalt Germanium enthält.

8. Ein Transistor nach einem der Ansprüche 1 bis 7, dadurch gekennzeichnet, daß die amorphe Silizium-Zone (13) ferner ein in bezug auf die n-Typ-Halbleiterschicht als p-Typ-Verunreinigung dienendes Element enthält.

9. Ein Feldeffekt-Transistor für integrierte Schaltungen, umfassend:
— ein halb-isolierendes Substrat;
— eine hochreine Halbleiterschicht auf dem halb-isolierenden Substrat;
— eine n-Typ-Halbleiterschicht (12), die oben auf der hochreinen Halbleiterschicht ausgebildet ist, um damit eine Heteroverbindung auszubilden;
— eine Schottky-Barriere-Gate-Elektrode (G); und
— Source- und Drain-Elektroden (S. D), abgelagert auf Teilen einer Hauptfläche der n-Typ-Halbleiter-Schicht (12), so daß sich die Gate-Elektrode (G) zwischen den Source- und Drain-Elektroden befindet;
dadurch gekennzeichnet, daß
— eine amorphe Silizium-Zone (13) auf einem Teil der Hauptfläche der n-Typ-Halbleiter-Schicht ausgebildet ist,
— die amorphe Silizium-Zone Bor in der Nachbarschaft von und mehr als 10 Atom% enthält; und
— eine Metallschicht (14) auf der amorphen Silizium-Zone (13) ausgebildet ist, um die Gate-Elektrode (G) zusammen mit der amorphen Silizium-Zone (13) zu bilden.

10. Ein Transistor nach Anspruch 9, dadurch gekennzeichnet, daß die amorphe Silizium-Zone (13) ferner zusätzlich zu dem Bor-Gehalt Germanium enthält.

11. Ein Transistor nach Anspruch 9 oder Anspruch 10, dadurch gekennzeichnet, daß die amorphe Silizium-Zone (13) ferner ein in bezug auf die n-Typ-Halbleiter-Schicht als p-Typ-Verunreinigung dienendes Element enthält.

12. Ein Feldeffekt-Transistor für integrierte Schaltungen, umfassend:
— ein n$^+$-Typ-Silizium-Substrat;
— eine n-Typ-Silizium-Schicht (12), die auf dem n$^+$-Typ-Silizium-Substrat ausgebildet ist;
— eine Merhzahl von Schottky-Barriere-Gate-Elektroden (G);
— eine an einem Teil einer Hauptfläche der n-Typ-Silizium-Schicht (12) gebildete Source-Elektrode, die zwischen den Gate-Elektroden (G) angeordnet ist; und
— eine auf der anderen Hauptfläche des n$^+$-Typ Silizium-Substrates ausgebildete Drain-Elektrode (D), die nicht mit der n-Typ Silizium-Schicht in Berührung steht, dadurch gekennzeichnet, daß

— amorphe Silizium-Zonen (13) auf der einen Hauptfläche der n-Typ- Silizium-Schicht ausgebildet sind;

— die amorphen Silizium-Zonen Bor in der Nachbarschaft von und mehr als 10 Atom% enthalten; und

— die Mehrzahl von Schottky-Barriere-Gate-Elektroden (G) jeweils auf den amorphen Silizium-Zonen (13) ausgebildet sind und zusammen mit den amorphen Silizium-Zonen eine Gate-Struktur bilden.

13. Ein Transistor nach Anspruch 12, dadurch gekennzeichnet, daß die amorphen Silizium-Zonen (13) ferner zusätzlich zu dem Bor-Behalt Germanium enthalten.

14. Ein Transistor nach Anspruch 12 oder Anspruch 13, dadurch gekennzeichnet, daß die amorphen Silizium-Zonen (13) ferner ein in bezug auf die n-Typ-Halbleiter-Schicht als p-Typ-Verunreinigung dienendes Element enthalten.

**Revendications**

1. Transistor à effet de champ pour circuits intégrés comprenant:

une couche semi-conductrice du type n (12);

une électrode de porte à barrière de Schottky (G); et

des électrodes (S, D) de source et de drainage formées sur des parties d'une surface principale de ladite couche semi-conductrice du type n (12) de sorte que ladite électrode de porte (G) se trouve entre les électrodes de source et de drainage; caractérisé en ce que une région de silicium amorphe (13) est formée sur une région de porte prospective de ladite surface principale de ladite couche semi-conductrice du type n (12); ladite région de silicium amorphe contient du bore en une concentration d'environ mais de plus dé 10 atome %;

une couche de métal (14) est déposée sur ladite région de silicium amorphe (13) de façon à constituer ladite électrode de porte (G) avec ladite région de silicium amorphe (13).

2. Transistor selon la revendication 1, caractérisé en ce que ladite région de silicium amorphe (13) à une structure électronique particulière qui comporte des états d'électrons localisés principalement provoqué par une localisation d'Anderson dans une région d'énergie comportant le niveau de Fermi, la densité dudit état d'électrons localisé au niveau de Fermi est supérieure à l'ordre $10^{19}$ cm$^{-3}$ · eV$^{-1}$, et la largeur de ladite région d'énergie est supérieure à 2 eV.

3. Transistor selon la revendication 1 ou la revendication 2, caractérisé en ce que ladite région de silicium amorphe (13) est formée par un procédé CVD.

4. Transistor selon l'une quelconque des revendications 1 à 3, caractérisé en ce que la couche semi-conductrice (12) du type n comporte un composé formant couche semi-conductrice (12) qui est formé sur un substrat (11) semi-isolant.

5. Transistor selon la revendication 4 caractérisé en ce que le composé formant couche semi-conductrice (12) et ledit substrat semi-isolant (11) sont fabriqués au moyen d'un matériau choisi dans le groupe consistant en GaAs, Ga$_x$Al$_{1-x}$AS et InP.

6. Transistor selon l'une quelconques des revendications 1 à 3 caractérisé en ce que la couche semi-conductrice du type n (12) comporte une couche de silicium mono-cristallin qui est formée sur un substrat isolant ou sur un substrat de silicium du type p ou dans un substrat de silicium du type p.

7. Transistor selon l'une quelconque des revendications 1 à 6 caractérisé en ce que la région de silicium amorphe (13) contient du germanium en addition audit contenu en bore.

8. Transistor selon l'une quelconque des revendications 1 à 7 caractérisé en ce que la région de silicium amorphe (13) contient en outre un élément servant en tant qu'impureté du type p par rapport à ladite couche semi-conductrice du type n.

9. Transistor à effet de champ pour circuits imprimés comprenant:

un substrat semi-isolant; une couche semi-conductrice de haute pureté sur ledit substrat semi-isolant;

une couche semi-conductrice du type n (12) formée au-dessus de ladite couche semi-conductrice à haute pureté de façon à constituer une hétéro-jonction avec cette dernière;

une électrode de porte (G) à barrière de Schottky; et

des électrodes (S, D) de source et de drainage déposées sur des parties d'une surface principale de ladite couche semi-conductrice du type n (12) de telle sorte que ladite électrode de porte (G) se trouve située entre les électrodes de source et de drainage;

caractérisé en ce qu'une région de silicium amorphe (13) est formée sur une partie de ladite surface principale de ladite couche semi-conductrice du type n; ladite région de silicium amorphe contient du bore au voisinage de et plus de 10 atome %; et

une couche de métal (14) est formée sur ladite région de silicium amorphe (13) de façon à constituer ladite électrode de porte (G) avec ladite région de silicium amorphe (13).

10. Un transistor selon la revendication 9 caractérisé en ce que la région de silicium amorphe (13) contient en outre du germanium en addition audit contenu en bore.

11. Transistor selon la revendication 9 ou la revendication 10 caractérisé en ce que ladite région de silicium amorphe (13) contient en outre un élément servant d'impureté du type p par rapport à ladite couche semi-conductrice du type n.

12. Transistor à effet de champ pour circuits intégrés comprenant:

un substrat de silicium du type n$^+$;

une couche de silicium du type n (12) formée sur ledit substrat de silicium du type $n^+$;

un certain nombre d'électrodes de porte à barrière de Schottky (G);

une électrode de source (S) formée sur une partie de la surface principale de ladite couche de silicium du type n (12) qui est située entre lesdites électrodes de porte (G); et

une électrode de drainage (D) formée sur l'autre surface principale dudit substrat de silicium du type $n^+$ qui n'est pas en contact avec ladite couche de silicium du type n;

caractérisé en ce que les régions de silicium amorphe (13) sont formées sur la première surface principale de ladite couche de silicium du type n;

lesdites régions de silicium amorphe contiennent du bore en une quantité voisine de, et supérieure à, 10 atome %; et

ladite pluralité d'électrodes de porte à barrière de Schottky (G) sont formées respectivement sur lesdites régions de silicium amorphe (13) et constituent une structure de porte avec lesdites régions de silicium amorphe.

13. Transistor selon la revendication 12 caractérisé en ce que les régions de silicium amorphe (13) contiennent en outre du germanium en addition audit contenu en bore.

14. Transistor selon la revendication 12 ou la revendication 13 caractérisé en ce que lesdites régions de silicium amorphe (13) contiennent en outre un élément servant en tant qu'impureté du type p par rapport à ladite couche semi-conductrice du type n.

F I G.1

F I G.2

F I G.3

1

F I G.4

F I G.5

RELATIOE VALUE OF MAX DRAIN CURRENT

(6-b)

(6-a)

BUILT-IN VOLTAGE (V)

# F I G.6

15(S)   14 } (G)   16(D)
         13
12
N   11

# F I G.7

15(S)   14' } (G)   16(D)
         14
         13   12
N   11

# F I G.8

3

FIG.9

FIG.10

FIG.11

FIG.12

4

F I G.13

F I G.14

F I G.15

F I G.16

F I G.17

F I G.18

F I G.19